(19) Europäisches Patentamt
European Patent Office
Office européen des brevets

(11) **EP 4 538 738 A1**

(12) **EUROPEAN PATENT APPLICATION**
published in accordance with Art. 153(4) EPC

(43) Date of publication:
**16.04.2025 Bulletin 2025/16**

(21) Application number: **23819840.2**

(22) Date of filing: **06.06.2023**

(51) International Patent Classification (IPC):
***G01S 7/4863*** (2020.01)     ***G01S 17/89*** (2020.01)
***H01L 27/146*** (2006.01)

(52) Cooperative Patent Classification (CPC):
**G01S 7/4863; G01S 17/89; G01S 17/894;
H10F 39/12**

(86) International application number:
**PCT/JP2023/020995**

(87) International publication number:
**WO 2023/238860 (14.12.2023 Gazette 2023/50)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **06.06.2022   JP 2022091696**

(71) Applicant: **Toppan Holdings Inc.
Tokyo 110-0016 (JP)**

(72) Inventor: **OOKUBO Yu
Tokyo 110-0016 (JP)**

(74) Representative: **Plasseraud IP
104 Rue de Richelieu
CS92104
75080 Paris Cedex 02 (FR)**

(54) **RANGE IMAGE IMAGING ELEMENT AND RANGE IMAGE IMAGING DEVICE**

(57)     An object of the present invention is to provide a range imaging element that is less likely to fail in the discharge or transfer of electric charge. The present invention is a range imaging element (32) provided on a semiconductor substrate and including, on the semiconductor substrate, a pixel circuit (321) including at least a photoelectric converter (PD) that generates electric charge, a charge storage (CS) that stores the electric charge, a transfer MOS transistor (G) provided on a transfer path for transferring the electric charge from the photoelectric converter to the charge storage, and a discharge MOS transistor (GD) provided on a discharge path for discharging the electric charge from the photoelectric converter. The photoelectric converter (PD) is N-gonal (N being an integer equal to or greater than 4) in plan view and provided on the semiconductor substrate. The transfer MOS transistor (G) and the discharge MOS transistor (GD) are each located on any side of the photoelectric converter (PD), and at least one of the transfer MOS transistor (G) and the discharge MOS transistor (GD) has a tapered shape that has a width dimension parallel with the side on which the MOS transistor is located and gradually decreasing within the photoelectric converter away from the side.

FIG.4

EP 4 538 738 A1

**Description**

[Technical Field]

The present invention relates to range imaging elements. The invention also relates to a range imaging apparatus that uses the range imaging elements.

This application claims the benefit of priority from Japanese Patent Application No. 2022-091696 filed in Japan on June 6, 2022, the description of which is incorporated herein by reference.

[Background Art]

Time-of-flight (hereinafter referred to as TOF) range image sensors have conventionally been used to measure the distance between a measurement device and an object by the time of flight of light in a space (measurement space) based on the fact that the speed of light is known. A TOF range image sensor emits an optical (e.g., near-infrared light) pulse to a measurement target and measures the distance between the measurement device and an object in the measurement space based on the difference between the time of the optical pulse emission and the time of reception of the optical pulse reflected by the object (reflected light), or specifically, the time of flight of light between the measurement device and the object (e.g., see Patent Literature 1).

When such a range imaging apparatus is used to accurately measure the distance to an object located within a predetermined range, the electric charge generated due to the light reflected from the subject needs to be transferred through a plurality of gates and accurately read out from the pixels.

A TOF range image sensor causes a photoelectric converter to convert the intensity of incident light into electric charge and store the resultant electric charge into a charge storage, and causes an AD converter to convert the analog voltage corresponding to the amount of the stored electric charge into a digital value.

The TOF range image sensor also determines the distance between the measurement device and the object based on information about the time of flight of light between the measurement device and the object included in the digital value and the analog voltage corresponding to the amount of the electric charge.

In the range imaging apparatus, the photoelectric converter stores the generated electric charge into each charge storage in the corresponding predetermined period, and the amount of electric charge stored in each charge storage is used to determine the delay time taken from the time of the optical pulse emission to the return of the optical pulse reflected by the subject. The range imaging apparatus uses the delay time and the speed of light to determine the distance from the apparatus to the subject.

To transfer electric charge from the photoelectric converter to the charge storages, the photoelectric converter and each charge storage have a transfer gate (transistor) through which electric charge is transferred. The photoelectric converter also has a discharge gate (transistor) through which electric charge resulting from conversion by the photoelectric converter is discharged during the period for which electric charge is discharged without being stored (drain period).

[Citation List]

[Patent Literature]

**[PTL** 1]
JP 4235729 B

[Summary of the Invention]

[Technical Problem]

However, discharge failure may occur when the electric charge is not completely discharged due to the layout of discharge gates.

For example, when a discharge gate located far away from the center of the photoelectric converter is turned on, the resultant potential gradient is gentler than that of a discharge gate located near the center of the photoelectric converter. **In** this case, for example, when high-intensity ambient light is received during a drain period, the electric charge cannot be completely discharged through the discharge gate. The electric charge that cannot be discharged through the discharge gate may enter the transfer gate, and if the electric charge that has entered the transfer gate is stored in the charge storage, the accuracy of distance measurement may deteriorate.

**In** view of the above circumstances, an object of the present invention is to provide a range imaging element that is less likely to fail in the discharge or transfer of electric charge.

Another object of the present invention is to provide a range imaging apparatus having improved distance measurement accuracy.

[Solution to Problem]

Aspect (1) of the present invention is a range imaging element provided on a semiconductor substrate and including: a photoelectric converter that generates electric charge; a charge storage that stores the electric charge; at least one transfer MOS transistor provided on a transfer path for transferring the electric charge from the photoelectric converter to the charge storage; and at least one discharge MOS transistor provided on a discharge path for discharging the electric charge from the photoelectric converter. The range imaging element includes, on a semiconductor substrate, a pixel circuit including at least the photoelectric converter, the charge storage, the transfer MOS transistor, and the discharge MOS transistor.

The photoelectric converter is N-gonal (N being an integer equal to or greater than 4) in plan view and provided on the semiconductor substrate.

The transfer MOS transistor and discharge MOS transistor are each located on any side of the photoelectric converter.

At least one of the transfer MOS transistor and the discharge MOS transistor has a tapered shape that has a width dimension parallel with the side on which the MOS transistor is located and gradually decreasing within the photoelectric converter away from the side.

Aspect (2) of the present invention is the range imaging element according to aspect (1) above, in which the photoelectric converter has a planar shape of a rectangle with long sides and short sides, the at least one transfer MOS transistor comprises 2M (M being an integer greater than or equal to 2) transfer MOS transistors, and the at least one discharge MOS transistor comprises 2n (n being an integer equal to or greater than 1) discharge MOS transistors. M of the transfer MOS transistors are located on each of the long sides line symmetrically about an x-axis parallel with the long sides and extending through the center of the photoelectric converter, and n of the discharge MOS transistors are located on each of the short sides.

Aspect (3) of the present invention is the range imaging element according to aspect (2) above, in which the transfer MOS transistors are located line symmetrically about a y-axis parallel with the short sides and extending through the center of the photoelectric converter.

Aspect (4) of the present invention is the range imaging element according to aspect (1) above, in which N is an integer equal to or greater than 5, the number of transfer MOS transistors and the number of discharge MOS transistors sum to N or more, and at least one of the transfer MOS transistors is provided on each side of the photoelectric converter except for the side on which the discharge MOS transistor is provided.

Aspect (5) of the present invention is the range imaging element according to any one of aspects (1) to (4) above, in which the transfer MOS transistors are located line symmetrically about an axis perpendicular to any side of the N-gon and extending through the center of the N-gon.

Aspect (6) of the present invention is the range imaging element according to any one of aspects (1) to (5) above, further including microlenses on the face of the pixel circuit to which the light is incident, the microlenses having an optical axis perpendicular to the plane of incidence of the photoelectric converter and aligned with the center of the plane of incidence.

Aspect (7) of the present invention is a range imaging apparatus including: a light reception unit including the range imaging element according to any one of aspects (1) to (6) above; and a range image processing unit that can calculate the distance from the range imaging element to a subject based on a range image taken by the range imaging element.

[Advantageous Effects of the Invention]

According to the present invention, a range imaging element can be provided in which failure to discharge or transfer electric charge can be suppressed.

[Brief Description of the Drawings]

Fig. 1 is a schematic block diagram illustrating a range imaging apparatus according to an embodiment of the present invention.

Fig. 2 is a schematic block diagram illustrating a range image sensor used in the range imaging apparatus.

Fig. 3 is a circuit diagram illustrating a pixel circuit provided in the range imaging apparatus and used in the range imaging apparatus.

Fig. 4 illustrates the arrangement of transistors in the pixel circuit.

Fig. 5A is a diagram illustrating the difference in potential in a photoelectric converter and transfer transistors due to gate shapes, illustrating the state of potential in each area.

Fig. 5B is a diagram illustrating the difference in potential in a photoelectric converter and transfer transistors due to gate shapes, illustrating the state of potential in each area.

Fig. 6A illustrates another example of gate shapes.

Fig. 6B illustrates yet another example of gate shapes.

Fig. 6C illustrates yet another example of gate shapes.

Fig. 7 illustrates a photoelectric converter and transistors according to a modification of the present invention.

Fig. 8 illustrates a range imaging element according to a modification of the present invention.

Fig. 9A illustrates a photoelectric converter and transistors according to a modification of the present invention.

Fig. 9B illustrates a photoelectric converter and transistors according to another modification of the present invention.

[Description of the Embodiments]

An embodiment of the present invention will now be described with reference to the drawings.

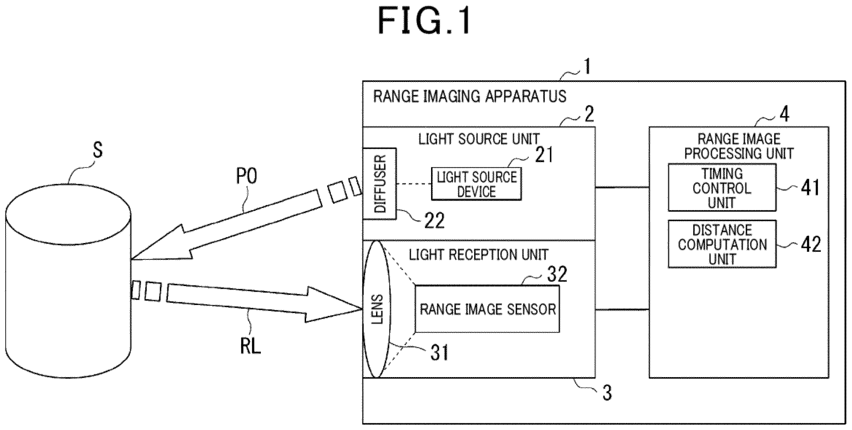

Fig. 1 is a schematic block diagram illustrating a range imaging apparatus 1. The range imaging apparatus 1 includes a light source unit 2, a light reception unit 3, and a range image processing unit 4. Fig. 1 also illustrates a subject S that undergoes distance measurement by the range imaging apparatus 1. The range imaging element is, for example, a range image sensor 32 (described later) in the light reception unit 3.

The light source unit 2 is controlled by the range image processing unit 4 to emit an optical pulse PO to a space to be imaged where the subject S that undergoes distance measurement by the range imaging apparatus 1 is located. The light source unit 2 is, for example, a surface emitting semiconductor laser module such as a vertical cavity surface emitting laser (VCSEL). The light source unit 2 includes a light source device 21 and a diffuser 22.

The light source device 21 is a light source that emits near-infrared laser light (e.g., in the wavelength range of 850 nm to 940 nm) as the optical pulses PO to be applied to the subject S. The light source device 21 is, for example, a semiconductor laser light emitting device. The light source device 21 is controlled by a timing control unit 41 to emit pulsed laser light.

The diffuser 22 is an optical component that diffuses the near-infrared laser light emitted from the light source device 21 to the extent of the surface applied to the subject S. The pulsed laser light diffused by the diffuser 22 is emitted as the optical pulse PO and applied to the subject S.

The light reception unit 3 receives reflected light RL that is the optical pulse PO reflected by the subject S subjected to distance measurement by the range imaging apparatus 1, and outputs a pixel signal corresponding to the received, reflected light RL. The light reception unit 3 includes a lens 31 and the range image sensor 32.

The lens 31 is an optical lens that guides the incident reflected light RL to the range image sensor 32. The lens 31 emits the incident reflected light RL to the range image sensor 32, causing the emitted light to be received by (incident on) pixel circuits contained in the light receiving area of the range image sensor 32.

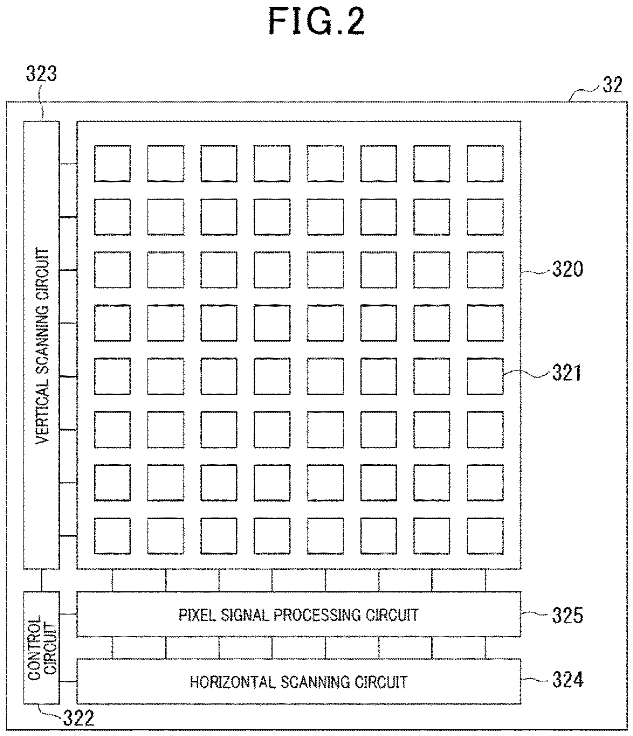

The range image sensor 32 is a range imaging element according to the present embodiment. As illustrated in Fig. 2, the range image sensor 32 includes multiple pixels in its two-dimensional light receiving area. The range image sensor 32 has pixel circuits (pixel circuits 321) each including a single photoelectric converter, a plurality of charge storages corresponding to the single photoelectric converter, and a component that distributes electric charge to each charge storage.

The range image sensor 32 is controlled by the timing control unit 41 included in the range image processing unit 4 to distribute the electric charge generated by the photoelectric converter to each charge storage. The range image sensor 32 also outputs a pixel signal corresponding to the amount of electric charge distributed to the charge storages. The range image sensor 32 has the multiple pixel circuits arranged in a two-dimensional matrix and outputs single-frame pixel signals corresponding to the pixel circuits.

The range image processing unit 4 controls the range imaging apparatus 1 and computes the distance to the subject S. The range image processing unit 4 includes the timing control unit 41 and a distance computation unit 42.

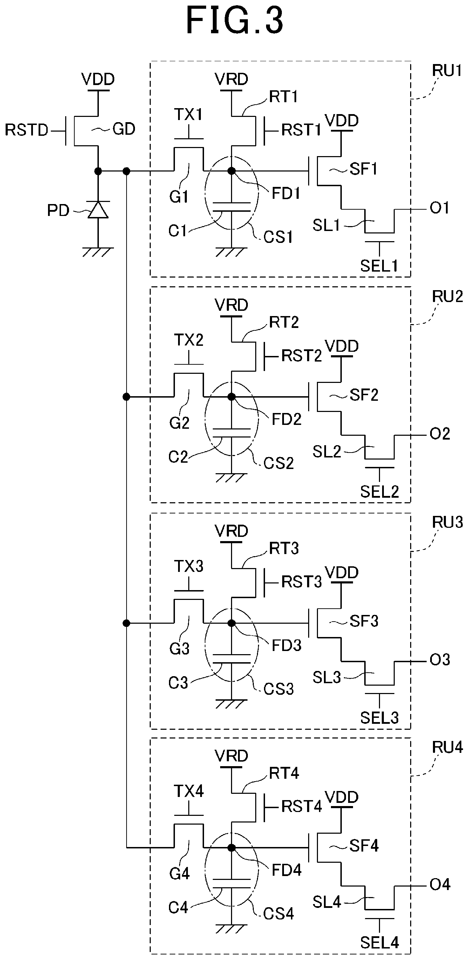

The timing control unit 41 controls the output timing of various control signals used for distance measurement. The various control signals refer to, for example, signals for controlling the emission of the optical pulse PO, signals for distributing the reflected light RL to the plurality of charge storages, and signals for controlling the number of distributions per frame. The number of distributions refers to the number of times the process of distributing electric charge to the charge storages CS (see Fig. 3) is repeated.

The distance computation unit 42 outputs the distance information obtained by computing the distance to the subject S based on the pixel signal output from the range image sensor 32. On the basis of the amount of electric charge stored in the plurality of charge storages CS, the distance computation unit 42 calculates a delay time Td taken from the emission of the optical pulse PO to the reception of the reflected light RL. The distance computation unit 42 computes the distance from the range imaging apparatus 1 to the subject S based on the calculated delay time Td.

In the range imaging apparatus 1 with this configuration, the light reception unit 3 receives the reflected light RL that is the near-infrared optical pulse PO emitted from the light source unit 2 to the subject S and reflected by the subject S, and the range image processing unit 4 outputs the distance information obtained by measuring the distance between the subject S and the range imaging apparatus 1.

Although Fig. 1 illustrates the range imaging apparatus 1 with the range image processing unit 4 disposed internally, the range image processing unit 4 may be a component disposed externally to the range imaging apparatus 1.

The configuration of the range image sensor 32 used as an imager in the range imaging apparatus 1 will now be described. Fig. 2 is a schematic block diagram illustrating the imager (the range image sensor 32).

As illustrated in Fig. 2, the range image sensor 32 includes, for example, a light receiving area 320 in which the multiple pixel circuits 321 are arranged, a control circuit 322, a vertical scanning circuit 323 having the function of distribution, a horizontal scanning circuit 324, and a pixel signal processing circuit 325.

The light receiving area 320 is an area in which the plurality of pixel circuits 321 are arranged, and Fig. 2 illustrates an example arrangement that is an 8 by 8 two-dimensional matrix. The pixel circuits 321 store the electric charge corresponding to the intensity of received light. The control circuit 322, for example, controls the operation of the components in the range image sensor 32 based on instructions from the timing control unit 41 in the range image processing unit 4.

The vertical scanning circuit 323 is a circuit controlled by the control circuit 322 to control each row of the pixel circuits 321 arranged in the light receiving area 320. The vertical scanning circuit 323 causes the voltage signal corresponding to the amount of the electric charge stored in the charge storages CS of the pixel circuits 321 to be output to the pixel signal processing circuit 325.

The pixel signal processing circuit 325 is controlled by the control circuit 322 to perform predetermined signal processing (e.g., noise suppression processing or A/D conversion processing) on the voltage signal output from the pixel circuits 321 in each column.

The horizontal scanning circuit 324 is a circuit controlled by the control circuit 322 to cause the signals output from the pixel signal processing circuit 325 to be output sequentially in time series. As a result, the pixel signals corresponding to the amount of the electric charge stored for a single frame are sequentially output to the range image processing unit 4. In the description below, pixel signals are digital signals obtained through A/D conversion by the pixel signal processing circuit 325.

The structure of the pixel circuits 321 arranged in the light receiving area 320 included in the range image sensor 32 will now be described. Fig. 3 is a circuit diagram illustrating an example structure of a pixel circuit 321. The pixel circuit 321 in Fig. 3 is a structural example including four pixel signal readout units.

The pixel circuit 321 includes a single photoelectric converter PD, a discharge transistor GD (GD1 and GD2 described later), and four pixel signal readout units RU (RU1 to RU4), each of which outputs a voltage signal through the corresponding output terminal O. Each pixel signal readout unit RU includes a transfer transistor G, a floating diffusion FD, a charge storage capacitor C, a reset transistor RT, a source follower transistor SF, and a selection transistor SL. The floating diffusion FD and the charge storage capacitor C form a charge storage CS.

In the pixel circuit 321 illustrated in Fig. 3, the pixel signal readout unit RU1, which outputs a voltage signal from an output terminal O1, includes a transfer transistor (transfer MOS transistor) G1, a floating diffusion FD1, a charge storage capacitor C1, a reset transistor RT1, a source follower transistor SF1, and a selection transistor SL1. In the pixel signal readout unit RU1, the floating diffusion FD1 and the charge storage capacitor C1 form a charge storage CS1. The pixel signal readout units RU2, RU3, and RU4 also have a similar configuration.

The photoelectric converter PD is an embedded photodiode that photoelectrically converts received light to generate electric charge corresponding to the received light (incident light) and stores the generated electric charge. In the present embodiment, the incident light comes from a space to be measured.

In the pixel circuit 321, the electric charge generated by the photoelectric converter PD through the photoelectric conversion of the incident light is distributed to the four charge storages CS (CS1 to CS4), and the voltage signals corresponding to the amounts of the distributed electric charge are output to the pixel signal processing circuit 325.

The pixel circuits arranged in the range image sensor 32 are not limited to a configuration including four pixel signal readout units RU (RU1 to RU4) as illustrated in Fig. 3, but may be pixel circuits having a configuration including 2M (M being an integer equal to or greater than 2) or more pixel signal readout units RU. That is, the pixel circuits may have a configuration including 2M (M being an integer equal to or greater than 2) or more transfer transistors G.

When the pixel circuit 321 of the range imaging apparatus 1 is driven, the optical pulse PO is emitted during an emission time To, and the reflected light RL is received by the range image sensor 32 after the elapse of a delay time Td. In synchronization with the emission of the optical pulse PO, the vertical scanning circuit 323 transfers the electric charge generated in the photoelectric converter PD to the charge storages CS1, CS2, CS3, and CS4 in this order and stores the electric charge in these charge storages.

In this process, the vertical scanning circuit 323 turns on the transfer transistor G1 provided on the transfer path through which the electric charge is transferred from the photoelectric converter PD to the charge storage CS1. This allows the electric charge produced by the photoelectric converter PD through photoelectric conversion to be stored into the charge storage CS1 through the transfer transistor G1. The vertical scanning circuit 323 then turns off the transfer transistor G1. This stops the transfer of the electric charge to the charge storage CS1. In this manner, the vertical scanning circuit 323 stores the electric charge into the charge storage CS1. The same applies to the other charge storages CS2, CS3, and CS4.

During the charge storage duration for which the electric charge is distributed to the charge storages CS, storage periods for feeding storage drive signals TX1, TX2, TX3, and TX4 to the transfer transistors G1, G2, G3, and G4, respectively, are repeated.

Through the transfer transistors G1, G2, G3, and G4, the electric charge corresponding to the incident light is transferred from the photoelectric converter PD to the charge storages CS1, CS2, CS3, and CS4. During the charge storage duration, the plurality of storage periods are repeated.

As a result, the electric charge is stored into the charge storages CS1, CS2, CS3, and CS4 respectively in the storage periods for the charge storages CS1, CS2, CS3, and CS4 during the charge storage duration.

When the storage periods for the charge storages CS1, CS2, CS3, and CS4 are repeated, after the end of the transfer of the electric charge to the charge storage CS4, the vertical scanning circuit 323 turns on the discharge transistor GD provided on the discharge path through which electric charge is discharged from the photoelectric converter PD.

Before the start of the storage period for the charge storage CS1, the discharge transistor GD thus discards the electric charge generated in the photoelectric converter PD after the previous storage period for the charge storage CS4 (i.e., resets the photoelectric converter PD).

The vertical scanning circuit 323 then causes each of all the pixel circuits 321 arranged in the light receiving area 320 to output a voltage signal to the pixel signal processing circuit 325 sequentially by each row (lateral line) of the pixel circuits 321.

The pixel signal processing circuit 325 performs signal processing such as A/D conversion on each received voltage signal and outputs the resultant signal to the horizontal scanning circuit 324.

The horizontal scanning circuit 324 outputs the voltage signals after the signal processing to the distance computation unit 42 sequentially in the order of the columns in the light receiving area 320.

The vertical scanning circuit 323 repeats, across one frame, storage of electric charge into the charge storages CS and discarding of electric charge produced by the photoelectric converter PD through photoelectric conversion as described above. As a result, the electric charge corresponding to the intensity of the light received by the range imaging apparatus 1 within a predetermined time period is stored into the charge storages CS. The horizontal scanning circuit 324 outputs the electrical signal corresponding to the amount of the one-frame electric charge stored in the charge storages CS to the distance computation unit 42.

Due to the relationship between the timing at which the optical pulse PO is emitted and the timing at which the electrical charge is stored into each of the charge storages CS (CS1 to CS4), the charge storage CS1 stores the electric charge corresponding to the ambient light component such as the background light before the emission of the optical pulse PO. In the charge storages CS2, CS3, and CS4, the electric charge corresponding to the reflected light RL and the ambient light component is distributed and stored. The allocation of the electric charge distributed to the charge storages CS2 and CS3 or the charge storages CS3 and CS4 (distribution ratio) represents a ratio that is based on the delay time Td taken for the optical pulse PO to be reflected by the subject S and enter the range imaging apparatus 1.

The distance computation unit 42 calculates the delay time Td based on the above principle using equation (1) or (2) below.

$$Td = To \times (Q3 - Q1)/(Q2 + Q3 - 2 \times Q1) \ ... \ (1)$$

$$Td = To + To \times (Q4 - Q1)/(Q3 + Q4 - 2 \times Q1) \ ... \ (2)$$

In the above equations, To represents the period of time during which the optical pulse PO is emitted, Q1 represents the amount of electric charge stored in the charge storage CS1, Q2 represents the amount of electric charge stored in the charge storage CS2, Q3 represents the amount of electric charge stored in the charge storage CS3, and Q4 represents the amount of electric charge stored in the charge storage CS4. For example, the distance computation unit 42 calculates the delay time Td using equation (1) when Q4 = Q1, and calculates the delay time Td using equation (2) when Q2 = Q1.

In equation (1), the electric charge generated due to the reflected light is stored in the charge storages CS2 and CS3, but not in the charge storage CS4. In equation (2), the electric charge generated due to the reflected light is stored in the charge storages CS3 and CS4, but not in the charge storage CS2.

In equation (1) or (2), it is assumed that, of the amount of electric charge stored in the charge storage CS2, CS3, and CS4, the amount of electric charge corresponding to the ambient light component is equal to the amount of electric charge stored in the charge storage CS1.

The distance computation unit 42 multiplies the delay time determined from equation (1) or (2) by the speed (velocity) of light to calculate the round trip distance to the subject S.

The distance computation unit 42 then divides the round trip distance calculated above by 2 to determine the distance to the subject S.

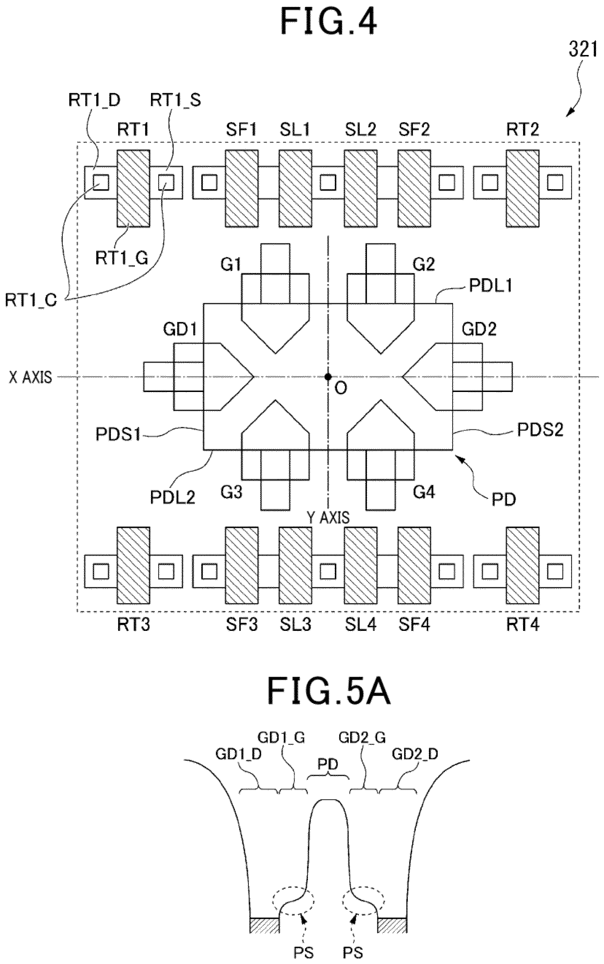

Fig. 4 illustrates an example of the arrangement (layout pattern) of the transistors of the pixel circuit 321 in the present embodiment.

Fig. 4 illustrates the layout pattern of the pixel circuit 321.

Fig. 4 also illustrates the arrangement of each pattern of the transfer transistors G1, G2, G3, and G4, the source follower transistors SF1, SF2, SF3, and SF4, the selection transistors SL1, SL2, SL3, and SL4, the reset transistors RT1, RT2, RT3, and RT4, the discharge transistors (discharge MOS transistors) GD1 and GD2, and the photoelectric converter PD. The above-described transistors are all n-channel MOS transistors provided on a p-type semiconductor substrate.

For example, the reset transistor RT1 includes a drain RT1_D (n-type diffusion layer (n-type impurity diffusion layer)), a source RT1_S (n-type diffusion layer), and a gate RT1_G on a p-type semiconductor substrate.

Contacts RT1_C are patterns representing contacts provided on each diffusion layer of the drain RT1_D (n-type diffusion layer) and the source RT1_S (n-type diffusion layer) of the reset transistor RT1 and connected to wires (not shown). The other transistors, or the transfer transistors G1 to G4, the source follower transistors SF1 to SF4, the selection transistors SL1 to SL4, the reset transistors RT2 to RT4, and the discharge transistors GD1 and GD2, also have a similar basic configuration.

The photoelectric converter PD is rectangular in plan view with a long side PDL1, a long side PDL2 parallel with the long side PDL1, a short side PDS1, and a short side PDS2 parallel with the short side PDS1.

The x-axis in Fig. 4 orthogonally crosses the short side PDS1 (and the short side PDS2) of the rectangular pattern of the photoelectric converter PD and passes through the center O of the rectangle. That is, the x-axis is an axis parallel with the long sides PDL1 and PDL2 of the rectangle and passing through the center O of the rectangle.

The y-axis is orthogonal to the x-axis, or orthogonally crosses the long side PDL1 (and the long side PDL2) of the rectangle, and passes through the center O of the rectangle. That is, the y-axis is an axis parallel with the short sides PDS1 and PDS2 of the rectangle and passing through the center O of the rectangle.

The discharge transistor GD1 is located on the x-axis passing through the short side PDS1 and perpendicular to the short side PDS1.

The discharge transistor GD2 is located on the x-axis passing through the short side PDS2 and perpendicular to the short side PDS2.

That is, the pixel circuit 321 includes the two discharge transistors GD1 and GD2, and the discharge transistor GD2 is positioned line symmetrically to the discharge transistor GD1 about the y-axis.

As described above, the discharge transistors GD1 and GD2 are located on the x-axis and positioned at the same distance from the y-axis. The discharge transistors GD1 and GD2 are thus located at the same distance from the center O of the photoelectric converter PD.

The transfer transistor G1 and the transfer transistor G2 are placed on the long side PDL1 line symmetrically about the y-axis.

The transfer transistor G3 and the transfer transistor G4 are placed on the long side PDL2 line symmetrically about the y-axis.

That is, the pixel circuit 321 includes the four transfer transistors, and the pair of transfer transistors G3 and G4 is positioned line symmetrically to the pair of transfer transistors G1 and G2 about the x-axis.

In the arrangement described above, the transfer transistors G1, G2, G3, and G4 are positioned at the same distance from the x-axis and also at the same distance from the center O of the photoelectric converter PD.

The transfer transistors G1 to G4 are the same size and shape in plan view as illustrated in Fig. 4 and have the same transistor characteristics.

This enables the photoelectric converter PD to generate electric charge having the same transfer efficiency (transfer characteristics), allowing electric charge to be stored in the charge storages CS1 to CS4 with the same transfer characteristics. Accordingly, the distance between the subject and the range imaging apparatus can be determined with high accuracy.

The reset transistors RT1 and RT2 are respectively placed line symmetrically to the reset transistors RT3 and RT4 about the x-axis.

The source follower transistors SF1 and SF2 are also respectively placed line symmetrically to the source follower transistors SF3 and SF4 about the x-axis.

Furthermore, the selection transistors SL1 and SL2 are also respectively placed line symmetrically to the selection transistors SL3 and SL4 about the x-axis.

Fig. 4 illustrates only the arrangement of the transistors on the semiconductor substrate of the pixel circuit 321, and the wiring pattern and the charge storage capacitors (C1 to C4) are not illustrated. The charge storages CS1, CS2, CS3, and CS4 are placed at the positions of the floating diffusions FD1, FD2, FD3, and FD4, respectively.

Each of the discharge transistors GD1 and GD2 includes a drain, a gate, and a source (the n-type diffusion layer of the photoelectric converter PD). The drain is connected to a power supply VDD via the contact and wiring.

The discharge transistors GD1 and GD2 each transfer electric charge (electrons) generated in the photoelectric converter PD to the drain when an H-level gate voltage is applied to the gate. The drain discharges the electric charge transferred from the photoelectric converter PD, to the power supply VDD.

Each of the transfer transistors G1, G2, G3, and G4 includes a floating diffusion (e.g., FD1 and FD2 in Fig. 3) as a drain, a gate, and a source (the n-type diffusion layer of the photoelectric converter PD). The floating diffusion has a charge storage provided therein. The drain is connected to the gate of the source follower transistor (e.g., SF1 and SF2 in Fig. 3) and the source of the reset transistor (e.g., RT1 and RT2 in Fig. 3) via the contacts and wiring.

The transfer transistor transfers the electric charge (electrons) generated in the photoelectric converter PD to the floating diffusion, which is the drain, when an H-level gate voltage is applied to the gate. The floating diffusion stores the electric charge transferred from the photoelectric converter PD.

As illustrated in Fig. 4, in the present embodiment, each gate of the transfer transistors G1 to G4 and the discharge transistors GD1 and GD2 is pentagonal in plan view. More specifically, the area extending from the floating diffusion to the photoelectric converter PD is rectangular, and the area overlapping the photoelectric converter PD is substantially triangular, extending at a constant width toward the inside of the photoelectric converter PD by a predetermined dimension and then gradually decreasing in width. For each transistor, the distal end of the gate is positioned at the center of the width of the transistor. The distal ends of the discharge transistors GD1 and GD2 are positioned on the x-axis.

In the course of the study of the appropriate transistor layout of the pixel circuit, the inventors have encountered a phenomenon in which failure to smoothly transfer or discharge electric charge results in the transfer or the discharge not being completed within a predetermined period and the electric charge migrating to an inappropriate site. Further study by the inventors has revealed that the planar shape of each gate is partially related to the phenomenon.

For example, Fig. 5A illustrates a potential state in a cross section along the x-axis of a semiconductor provided with the pixel circuit 321, in which the gate of each discharge transistor GD has an area overlapping the photoelectric converter PD, and the width dimension (i.e., the width in the y-direction) of the area is constant at any position along the x-axis. Fig. 5A illustrates the potential state across each area of the discharge transistor GD1 with a constant dimension in the y-direction, the photoelectric converter PD, and the discharge transistor GD2 with a constant dimension in the y-direction, with the horizontal axis representing the position in the area. In Fig. 5A, the vertical axis represents the potential level (the potential increases as the height decreases). As illustrated in Fig. 5A, the areas of gates GD1_G and GD2_G have shoulders PS having a shallow potential gradient, and it has been found that electric charge is less likely to migrate in an area including a shoulder PS. This phenomenon becomes more pronounced as the distance between the discharge transistors GD1 and GD2 increases.

On the basis of this observation, the inventors have resolved the issue by tapering the planar shape of each gate of the discharge transistors GD1 and GD2 in such a way that the width dimension decreases toward the distal end of the gates GD1_G and GD2_G. That is, the discharge transistors GD1 and GD2 have a tapered shape that has a width dimension (i.e., width in the y-direction) parallel with the sides PDS1 and PDS2 on which the discharge transistors are located and gradually decreasing within the photoelectric converter PD away from the sides PDS1 and PDS2 of the photoelectric converter PD.

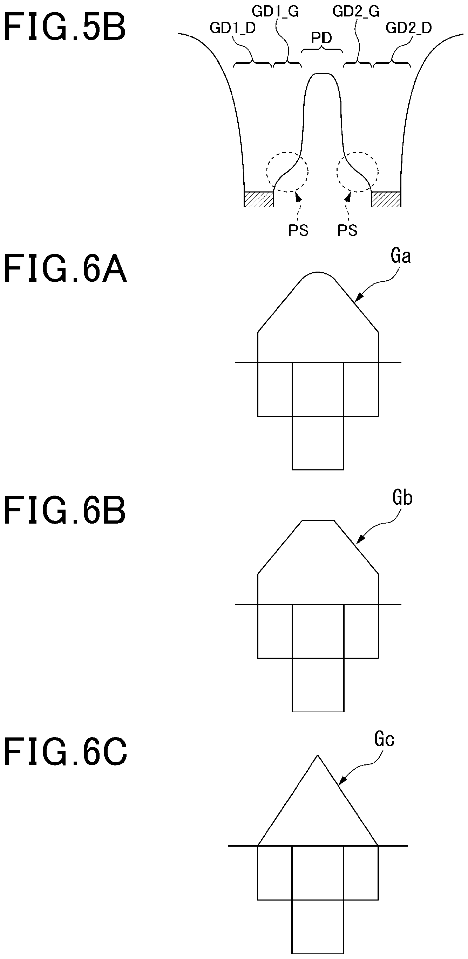

Fig. 5B illustrates the results of simulation of potential gradients for the gates GD1_G and GD2_G of the discharge transistors GD1 and GD2 according to the present embodiment. GD1_D and GD2_D respectively denote the drains of the discharge transistors GD1 and GD2. As denoted by reference sign PS, the gradients in the areas that have shallow gradients in Fig. 5A (shoulders PS) are sharpened in Fig. 5B, and electric charge is expected to migrate more smoothly.

Although Figs. 5A and 5B illustrate an example of the discharge transistors, the same effects occur in the transfer transistors G1 to G4, and electric charge is expected to migrate more smoothly. That is, as illustrated in Fig. 4, the transfer transistors G1 or G4 have a tapered shape in plan view that has a width dimension (i.e., width in the x-direction) parallel with the side PDL1 or PDL2 on which the transfer transistor is located and gradually decreasing within the photoelectric converter PD away from the side PDL1 or PDL2 of the photoelectric converter PD. Accordingly, electric charge seems to migrate more smoothly.

As described above, the range image sensor 32 (range imaging element) according to the present embodiment includes, on a semiconductor substrate, the pixel circuit 321 including at least the photoelectric converter PD that generates electric charge corresponding to incident light received from a space to be measured, the charge storage CS that stores the electric charge, the transfer MOS transistors (the transfer transistors G1, G2, G3, and G4) provided on a transfer path for transferring the electric charge from the photoelectric converter PD to the charge storage CS, and the discharge MOS transistors (the discharge transistors GD1 and GD2) provided on a discharge path for discharging the electric charge from the photoelectric converter PD.

The photoelectric converter PD is quadrangular in plan view and provided on the semiconductor substrate, the transfer MOS transistors and the discharge MOS transistors are located on any side (PDL1, PDL2, PDS1, or PDS2) of the photoelectric converter PD, and the transfer MOS transistors and the discharge MOS transistors have a tapered shape that has a width dimension parallel with the sides on which the MOS transistors are located and gradually decreasing within the photoelectric converter PD away from the sides of the photoelectric converter **PD.**

This structure suppresses failure of discharge or transfer of electric charge. As a result, the transistor layout is more flexible since the transistors may be arranged even in, for example, positional relationships in which good operation is difficult to achieve with a conventional structure.

The range imaging apparatus 1 according to the present embodiment includes the light reception unit 3 that includes the above-mentioned range imaging element, and the range image processing unit 4 that can calculate the distance from the range imaging element to the subject S based on a range image taken by the range imaging element.

This can improve the accuracy of distance measurement by the range imaging apparatus.

The gate of each transistor according to the present embodiment achieves the above-mentioned effects as long as the width dimension decreases within the photoelectric converter **PD** away from the side that forms the edge of the photoelectric converter, and thus the specific shape of the gate is not limited to the above example. Accordingly, the distal end may be rounded as for a gate Ga illustrated in Fig. 6A, or the distal end may be flat as for a gate Gb illustrated in Fig. 6B. Alternatively, as for a gate Gc illustrated in Fig. 6C, the gate shape may be substantially triangular without a part that has a constant width dimension within the photoelectric converter.

The gate shapes according to the present embodiment may be relatively easily achieved using a known technique by, for example, modifying the mask for production.

Tapered gates also have the advantage of being less likely to interfere with other nearby gates when placed.

For example, when transistors with gates that are rectangular in plan view are placed on adjacent long and short sides of a rectangular photoelectric converter near its corner, the distal ends of the gates are likely to interfere with each other, which limits the arrangement. However, a tapered gate has a distal end with a small width dimension as well as the side edges of the gate are sloped, and thus adjacent gates are less likely to interfere with each other. As a result, since two transistors may be placed closer together than transistors with rectangular gates, the transistor layout is still more flexible.

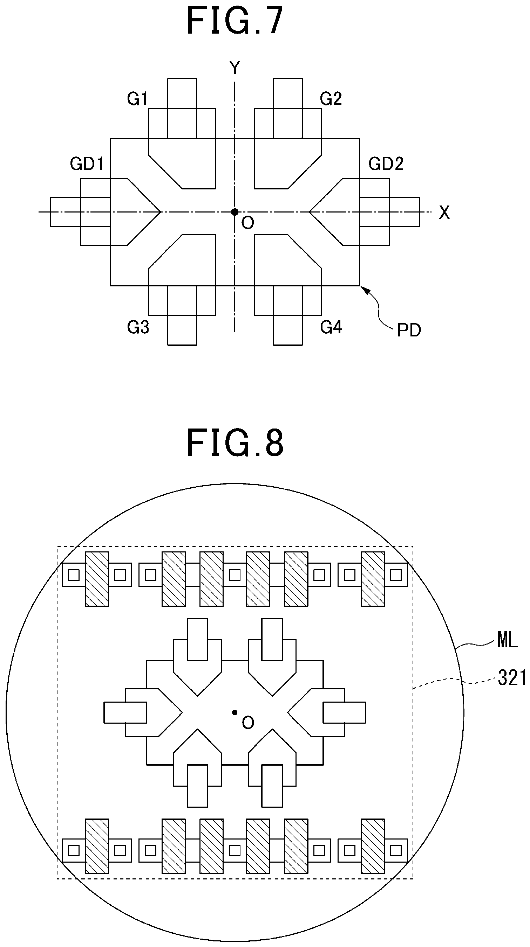

In view of the perspectives mentioned above, the tapered gate shape may not have symmetrical sides. For example, for transfer transistors G1 to G4 in a modification illustrated in Fig. 7, a gate may be tapered to have a slope in only the side facing the discharge transistor across the corner of the photoelectric converter PD.

Although one embodiment of the present invention has been described in detail, the present invention is not limited to a particular embodiment but includes structural modifications or combinations that fall within the spirit and scope of the invention. Although some, but not all, modifications are illustrated below, other modifications are possible. Two or more modifications may be combined.

For example, the number of discharge transistors GD is not limited to two, but 2n (n being an integer equal to or greater than 1) discharge transistors GD may be used, with n discharge transistors located on each of the short sides. The number of transfer transistors is not limited to four, but 2M (M being an integer greater than or equal to 2) transfer transistors may be used, with M transfer transistors located on each of the long sides. The M transfer transistors located on one long side may be placed line symmetrically about the x-axis.

At least one of the set of transfer MOS transistors and the set of discharge MOS transistors may have a tapered shape that has a width dimension parallel with the side on which the MOS transistors are located and gradually decreasing within the photoelectric converter PD away from the side of the photoelectric converter PD. This structure can suppress failure of discharge or transfer of electric charge.

- The range imaging element according to the present invention may also include a micro-lens on the face of the pixel circuit to which the light is incident. As illustrated in Fig. 8, the optical axis of a micro-lens ML is aligned with the center O of the photoelectric converter and perpendicular to the plane of incidence of the light, so that the micro-lens ML can appropriately guide the incident light to the photoelectric converter PD to improve sensitivity.

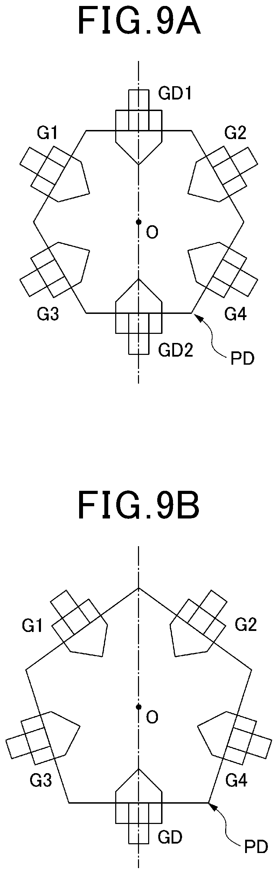

- The planar shape of the photoelectric converter according to the present invention is not limited to a rectangle but may be an N-gon (N being an integer equal to or greater than 4). As other examples, Fig. 9A illustrates an example configuration of a photoelectric converter PD having a planar shape of a regular hexagon, whereas Fig. 9B illustrates an example configuration of a photoelectric converter PD having a planar shape of a regular pentagon.

The example configuration of a regular hexagon includes six transistors: four transfer MOS transistors G1 to G4 and two discharge MOS transistors GD1 and GD2. The four transfer MOS transistors are placed one-to-one on the sides on which the discharge MOS transistor GD1 or GD2 is not provided, and the transfer MOS transistors are perpendicular to the sides on which the discharge MOS transistors are provided, and placed line symmetrically about the axis extending through the center O of the photoelectric converter (illustrated by a dashed line in the figure).

The example configuration of a regular pentagon includes five transistors: four transfer MOS transistors G1 to G4 and one discharge MOS transistor GD. The four transfer MOS transistors are placed one-to-one on the sides on which the discharge MOS transistor GD is not provided. The transfer MOS transistors are perpendicular to the side on which the discharge MOS transistor is provided, and placed line symmetrically about the axis extending through the center O of the photoelectric converter (illustrated by a dashed line in the figure).

That is, the photoelectric converter is N-gonal in plan view (N being an integer equal to or greater than 5), the transfer MOS transistors and the discharge MOS transistors GD sum to N or more, and at least one transfer MOS transistor may be provided on each side of the photoelectric converter PD except for the sides on which the discharge MOS transistors GD are provided.

The transfer MOS transistors may be perpendicular to any side of the N-gon, which is the planar shape of the photoelectric converter PD, and placed line symmetrically about the axis extending through the center of the N-gon.

This configuration also achieves the same effects as the range imaging element according to the embodiment described above.

- When the photoelectric converter is quadrangular in plan view, the specific shape is not limited to a rectangle but may be, for example, a square. Because a square photoelectric converter has sides that are all the same length and no long or short sides, the discharge MOS transistors may be provided on any pair of opposite sides.

[Reference Signs List]

1 Range imaging apparatus
3 Light reception unit
4 Range image processing unit
32 Range image sensor (range imaging element)
321 Pixel circuit
CS Charge storage
G1, G2, G3, G4 Transfer transistor (transfer MOS transistor)
GD, GD1, GD2 Discharge transistor (discharge MOS transistor)
ML Micro-lens
PD Photoelectric converter

**Claims**

1. A range imaging element provided on a semiconductor substrate, the range imaging element comprising:

    a photoelectric converter configured to generate electric charge corresponding to incident light received from a space to be measured;
    a charge storage configured to store the electric charge;
    at least one transfer MOS transistor provided on a transfer path for transferring the electric charge from the photoelectric converter to the charge storage; and

at least one discharge MOS transistor provided on a discharge path for discharging the electric charge from the photoelectric converter,

wherein the range imaging element includes, on a semiconductor substrate, a pixel circuit including at least the photoelectric converter, the charge storage, the transfer MOS transistor, and the discharge MOS transistor,

the photoelectric converter is N-gonal (N being an integer equal to or greater than 4) in plan view and provided on the semiconductor substrate,

the transfer MOS transistor and the discharge MOS transistor are each located on any side of the photoelectric converter, and

at least one of the transfer MOS transistor and the discharge MOS transistor has a tapered shape that has a width dimension parallel with the side on which the MOS transistor is located and gradually decreasing within the photoelectric converter away from the side of the photoelectric converter.

2. The range imaging element according to claim 1, wherein

the photoelectric converter has a planar shape of a rectangle with long sides and short sides,

the at least one transfer MOS transistor comprises 2M (M being an integer greater than or equal to 2) transfer MOS transistors, and the at least one discharge MOS transistor comprises 2n (n being an integer equal to or greater than 1) discharge MOS transistors,

M of the transfer MOS transistors are located on each of the long sides line symmetrically about an x-axis parallel with the long sides and extending through a center of the photoelectric converter, and

n of the discharge MOS transistors are located on each of the short sides.

3. The range imaging element according to claim 2, wherein
the transfer MOS transistors are located line symmetrically about a y-axis parallel with the short sides and extending through the center of the photoelectric converter.

4. The range imaging element according to claim 1, wherein

N is an integer equal to or greater than 5,

the transfer MOS transistors and the discharge MOS transistor sum to N or more, and

at least one of the transfer MOS transistors is provided on each side of the photoelectric converter except for the side on which the discharge MOS transistors is provided.

5. The range imaging element according to claim 4, wherein
the transfer MOS transistors are located line symmetrically about an axis perpendicular to any side of the N-gon and extending through a center of the N-gon.

6. The range imaging element according to claim 1, further comprising:
a micro-lens on a face of the pixel circuit to which the light is incident, the micro-lens having an optical axis perpendicular to a plane of incidence of the photoelectric converter and aligned with a center of the plane of incidence.

7. A range imaging apparatus comprising:

a light reception unit including the range imaging element according to any one of claims 1 to 6; and

a range image processing unit configured to calculate a distance from the range imaging element to a subject based on a range image taken by the range imaging element.

# FIG.1

RANGE IMAGING APPARATUS 1

LIGHT SOURCE UNIT 2

DIFFUSER 22

LIGHT SOURCE DEVICE 21

LIGHT RECEPTION UNIT

LENS 31

RANGE IMAGE SENSOR 32

3

RANGE IMAGE PROCESSING UNIT 4

TIMING CONTROL UNIT 41

DISTANCE COMPUTATION UNIT 42

S

PO

RL

EP 4 538 738 A1

# FIG.2

323

32

VERTICAL SCANNING CIRCUIT

320

321

CONTROL CIRCUIT

PIXEL SIGNAL PROCESSING CIRCUIT — 325

HORIZONTAL SCANNING CIRCUIT — 324

322

# FIG.3

# FIG.4

# FIG.5A

FIG.5B

GD1_D GD1_G PD GD2_G GD2_D

PS  PS

FIG.6A

Ga

FIG.6B

Gb

FIG.6C

Gc

# FIG.7

# FIG.8

# FIG.9A

# FIG.9B

# EP 4 538 738 A1

<table>
<tr><td colspan="2">INTERNATIONAL SEARCH REPORT</td><td colspan="2">International application No.<br>**PCT/JP2023/020995**</td></tr>
</table>

**A. CLASSIFICATION OF SUBJECT MATTER**

*G01S 7/4863*(2020.01)i; *G01S 17/89*(2020.01)i; *H01L 27/146*(2006.01)i
FI: G01S7/4863; G01S17/89; H01L27/146 A

According to International Patent Classification (IPC) or to both national classification and IPC

**B. FIELDS SEARCHED**

Minimum documentation searched (classification system followed by classification symbols)

G01S7/48 - G01S7/51; G01S17/00 - G01S17/95; G01C3/00 - G01C3/32; H01L27/146; H04N25/705

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2022-71538 A (TOPPAN PRINTING CO LTD) 16 May 2022 (2022-05-16)<br>abstract, paragraphs [0015]-[0063], fig. 1-7 | 1-3, 6-7 |
| Y | JP 2022-71539 A (TOPPAN PRINTING CO LTD) 16 May 2022 (2022-05-16)<br>abstract, paragraphs [0016]-[0070], fig. 1-7 | 1, 4-7 |
| Y | JP 2017-162886 A (RICOH CO LTD) 14 September 2017 (2017-09-14)<br>abstract, paragraphs [0009]-[0061], fig. 1-4 | 1-7 |
| A | JP 2021-197388 A (SONY SEMICONDUCTOR SOLUTIONS CORP) 27 December 2021 (2021-12-27)<br>entire text, all drawings | 1-7 |
| A | US 2021/0199781 A1 (SAMSUNG ELECTRONICS CO., LTD.) 01 July 2021 (2021-07-01)<br>entire text, all drawings | 1-7 |

☐ Further documents are listed in the continuation of Box C.      ☑ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **19 July 2023** | **01 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/020995**

| Patent document cited in search report | | | Publication date (day/month/year) | Patent family member(s) | | | Publication date (day/month/year) |
|---|---|---|---|---|---|---|---|
| JP | 2022-71538 | A | 16 May 2022 | WO | 2022/091563 | A1 | |
| | | | | abstract, paragraphs [0015]-[0063], fig. 1-7 | | | |
| | | | | CN | 116209915 | A | |
| | | | | TW | 202223435 | A | |
| JP | 2022-71539 | A | 16 May 2022 | WO | 2022/091564 | A1 | |
| | | | | abstract, paragraphs [0016]-[0070], fig. 1-7 | | | |
| | | | | CN | 116235025 | A | |
| | | | | TW | 202224165 | A | |
| JP | 2017-162886 | A | 14 September 2017 | US | 2017/0256575 | A1 | |
| | | | | abstract, paragraphs [0008], [0024]-[0074], fig. 1-4 | | | |
| JP | 2021-197388 | A | 27 December 2021 | US | 2023/0154950 | A1 | |
| | | | | entire text, all drawings | | | |
| | | | | WO | 2021/251152 | A1 | |
| | | | | CN | 115699317 | A | |
| US | 2021/0199781 | A1 | 01 July 2021 | KR | 10-2021-0084752 | A | |
| | | | | entire text, all drawings | | | |
| | | | | CN | 113050065 | A | |

Form PCT/ISA/210 (patent family annex) (January 2015)

**REFERENCES CITED IN THE DESCRIPTION**

**Patent documents cited in the description**

- JP 2022091696 A
- JP 4235729 B